# EUROPEAN PATENT APPLICATION

(11) **EP 1 524 551 A1**
(43) Date of publication of application: **20.04.2005**
(21) Application number: 03741522.1
(22) Date of filing: 22.07.2003
(51) Int. Cl.: G03B 33/14

(54) **ORGANIC ELECTROLUMINESCENCE DEVICE**

(30) Priority: 22.07.2002 JP 2002212419
(71) Applicant: IDEMITSU KOSAN CO., LTD., Tokyo 100-8321 (JP)
(72) Inventor: HOSOKAWA, Chishio, Sodegaura-shi, Chiba 299-0293 (JP); MATSUURA, Masahide, Sodegaura-shi, Chiba 299-0293 (JP); IWAKUMA, Toshihiro, Sodegaura-shi, Chiba 299-0293 (JP); INOUE, Kazuyoshi, Sodegaura-shi, Chiba 299-0293 (JP)
(74) Representative: Gille Hrabal Struck Neidlein Prop Roos
(86) International application number: PCT/JP2003/009236
(87) International publication number: WO 2004/017137

(57) **Abstract**

An organic luminescence device including an anode (1); an insulating or semiconductive inorganic thin film layer (3) having an energy gap of 2. 7 eV or more; an organic compound layer (4) comprising one or more layers which include at least an organic emitting layer, at least one of the layers including an ortho-metallized metal complex; and a cathode (2) in order of the description of these members. The formation of the inorganic thin film layer (3) improves the injection of holes into the emitting layer, and the addition of the ortho-metallized metal complex permits the use of triplet excitons. Therefore, the light emitting efficiency, luminance and lifespan thereof are improved.

## Description

### Technical Field

The present invention relates to an organic luminescence device, in particular, an organic electroluminescence device.

### Background Art

Organic luminescence devices have been expected to be used for various articles, such as displays, backlights for LCD, light sources for illumination, light sources for optical communication, and reading and writing heads for information files, and in recent years, active research and development thereon have been advanced.

In general, an organic electroluminescence device (hereinafter referred to as an organic EL device) is composed of an organic compound layer having a film thickness of 1 µm or less and two electrodes between which the organic compound layer is sandwiched. Such an organic luminescence device is a spontaneously light emitting type element wherein electrons generated from one (cathode) of the electrodes and holes generated from the other electrode (anode) are recombined in the organic compound layer by the application of electrical voltage to the electrodes across them, so that the luminescent material is excited to emit light.

In the case that an organic EL device is simple-matrix-driven, a higher luminance is required as the duty ratio is made larger. In general, however, the luminescence efficiency becomes lower as the luminance is made higher. Accordingly, the problem is overcome by dividing the screen thereof, and in the present circumstances, the duty ratio is controlled into about 1/120 or less.

Under such a situation, it was recently reported that excitons in the state of triplets can be used in an organic EL device containing, in its organic compound layer, a tris(2-phenylpyridine)iridium complex and this element exhibits a high luminance and a high luminescence efficiency; and attention has been paid thereto (Applied Physics Letters, 75, 4(1999)).

However, in the case that an organic compound layer containing a tris (2-phenylpyridine) iridium complex is directly jointed to an anode or cathode, a high voltage is required for the injection of electric charges into the organic compound layer, so that the voltage becomes high and further the power consumption becomes large. Thus, problems, such as the generation of heat, are caused. Furthermore, a problem that the lifespan thereof is very short is also caused.

Therefore, organic EL devices which are driven at a lower voltage have been desired, and JP-A-2001-244077 discloses an organic EL device wherein a tris(2-phenylpyridine)iridium complex is contained in an organic compound layer and an inorganic semiconductor layer is used as a hole injecting layer.

The following are disclosed as the inorganic semiconductor used in the inorganic semiconductor layer: Si₁₋ₓCx, CuI, CuS, GaAs, ZnTe, Cu₂O, Cu₂S, CuSCN, CuCl, CuBr, CuInSe₂, CuInS₂, CuAlSe₂, CuGaSe₂, CuGaS₂, GaP, NiO, CoO, FeO, Bi₂O₃, MoO₂, Cr₂O₃, and so on. However, these have an energy gap of not more than 2.5 to 2.6 eV, and have no electron barrier property so as to have a low capability of causing electrons to remain in the luminescent layer. Thus, improvement has been desired.

Since these inorganic semiconductors have a small energy gap, they have quenching effect onto the triplet excitation state generated in the emitting layer. Thus, it has been desired that the problem is solved.

In light of the above-mentioned problems, an object of the present invention is to provide an organic luminescence device which is driven at a low voltage, exhibits a high luminance and a high luminescence efficiency, and has an improved lifespan.

### Disclosure of the Invention

In order to solve the problems, the inventors have made eager researches to find out that an organic luminescence device having an insulating or semiconductive inorganic thin film layer having an energy gap of 2.7 eV or more and an organic compound layer containing an ortho-metallized metal complex is driven at a low voltage, and has a high luminance and a superior luminescence efficiency. Thus, the present invention has been made.

According to the present invention, the following organic luminescence device and organic luminescence substrate can be provided.
[1] An organic luminescence device comprising:
   an anode;
   an insulating or semiconductive inorganic thin film layer having an energy gap of 2.7 eV or more;
   an organic compound layer comprising one or more layers which comprise at least an organic emitting layer, at least one of the layers containing an ortho-metallized metal complex; and
   a cathode in order of the description of these members.
[2] The organic luminescence device according to [1], wherein the inorganic thin film layer comprises one or more metals or compounds selected frommetals, metal calcogenides, oxynitrides, carbides, nitrides, silicides and borides.
[3] The organic luminescence device according to [2], wherein themetal(s) is/are one or more metals selected from the following A group;
   A group: In, Sn, Ga, Si, Ge, Zn, Cd, Mg, Al, Ta and Ti.
[4] The organic luminescence device according to [1] or [2], wherein the inorganic thin film layer comprises two or more selected from oxides, oxynitrides, carbides, and nitrides of In, Sn, Ga, Si, Al, Ta, Ti, Ge, Zn, Cd and Mg.
[5] The organic luminescence device according to [1] or [2], wherein the inorganic thin film layer is made mainly of at least one of oxides of In, Sn and Ga.
[6] The organic luminescence device according to[1] or [2], wherein the inorganic thin film layer is made mainly of (Si₁₋ₓGeₓ)O_{y} wherein 0 < x < 1, and 1.7 < y < 2.2.
[7] The organic luminescence device according to [2] or [3], wherein at least one of the metals or compounds has a work function of 4.5 eV or more.
[8] The organic luminescence device according to [2], wherein the metals are two or more metals comprising one or more metals selected from the following A group; and one or more metals selected from the following B group;
   A group: In, Sn, Ga, Si, Ge, Zn, Cd, Mg, Al, Ta and Ti;
   B group: metals having a work function of 4.5 eV or more.
[9] The organic luminescence device according to [8], wherein the metals in the B group are atoms belonging to any one of the groups IIIB, IVB, VB, VIB and VIIB in the periodic table (long period type).
[10] The organic luminescence device according to [8], wherein the metals in the B group are Au, Ni, Cr, Ir, Nb, Pt, W, Mo, Ta, Pd, Ru, Ce, V, Zr, Re, Bi and Co.
[11] The organic luminescence device according to [2], wherein the metal (s) is/are one or more metals selected from the following C group;
   C group: Ce, Pr, Nd, Sm, Eu, Gd, Tb, Dy, Ho, Er, Tm, Yb, and Lu.
[12] The organic luminescence device according to [2], wherein the metals are two or more metals comprising one or more metals selected from the following A group; and one or more metals selected from the following C group;
   A group: In, Sn, Ga, Si, Ge, Zn, Cd, Mg, Al, Ta and Ti;
   C group: Ce, Pr, Nd, Sm, Eu, Gd, Tb, Dy, Ho, Er, Tm, Yb, and Lu.
[13] The organic luminescence device according to any one of [2], [3] and [7] to [12], wherein the compounds are calcogenides or nitrides.
[14] The organic luminescence device according to any one of [2], [3] and [7] to [12], wherein the compounds are oxides, carbides, nitrides, silicides, and borides.
[15] The organic luminescence device according to any one of [2] to [4] and [7] to [14], wherein the compounds are oxides.
[16] The organic luminescence device according to any one of [2] to [4] and [7] to [15], wherein the inorganic thin film layer comprises an oxide.
[17] The organic luminescence device according to [1] or [2], wherein the inorganic thin film layer is made mainly of at least one oxide selected from oxides of Ce, Pr, Nd, Sm, Eu, Gd, Tb, Dy, Ho, Er, Tm, Yb, and Lu.
[18] The organic luminescence device according to any one of [2] to [17], wherein the inorganic thin film layer comprises two or more metals or compounds.
[19] The organic luminescence device according to any one of [1] to [18], wherein the inorganic thin film layer has a hole-injecting property.
[20] The organic luminescence device according to any one of [1] to [19], wherein the ionization energy of the inorganic thin film layer is more than 5.6 eV.
[21] The organic luminescence device according to any one of [1] to [20], wherein the ortho-metallized metal complex is an iridium complex.
[22] The organic luminescence device according to any one of [1] to [21], wherein the organic emitting layer comprises a polymer compound as a host material.
[23] An organic emitting substrate wherein the organic luminescence device according to any one of [1] to [22] is arranged on a plastic substrate.

### Brief Description of the Drawing

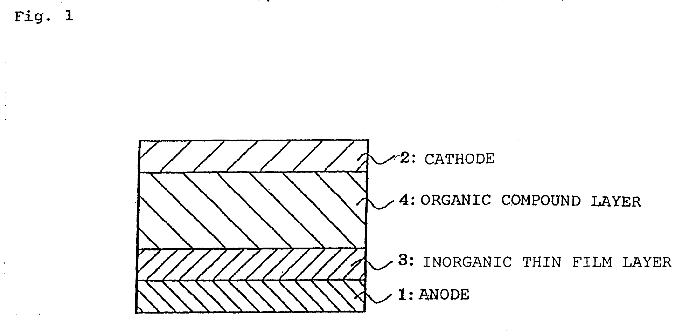

FIG. 1 is a view illustrating an organic luminescence device according to an embodiment of the present invention.

### Best Modes for Carrying Out the Invention

As illustrated in Fig. 1, an organic luminescence device of the present invention has at least an inorganic thin film layer 3 and an organic compound layer 4 between a pair of electrodes of an anode 1 and a cathode 2.

The organic compound layer is made of a single layer or plural layers, comprises at least an organic emitting layer, and may comprise, for example, an organic hole injecting layer, an organic hole transporting layer, an electron transporting layer, and an electron injecting layer besides the organic emitting layer.

About the organic luminescence device of the present invention, the following structures can be exemplified as the specific structure laminated on a substrate:
Anode/hole injecting layer/organic emitting layer/cathode
Anode/hole injecting layer/hole transporting layer/organic emitting layer/cathode
Anode/hole injecting layer/organic emitting layer/electron transporting layer/cathode
Anode/hole injecting layer/hole transporting layer/organic emitting layer/electron transporting layer/cathode

These may be laminated in a reverse order onto the substrate.

Usually, the anode is a transparent electrode, and the cathode is a metal electrode.

Plural hole transporting layers, electron transporting layers or other layers may be formed, and an electron injecting layer may be formed between the cathode and an organic emitting layer or electron transporting layer. An electroconductive polymer layer may be formed between a hole injecting layer and a hole transporting layer or organic emitting layer. It is preferred that a block layer is formed on the cathode side surface of an emitting layer in order for holes not to enter the cathode.

The following specifically describes the constituent members of the present invention, in particular, the inorganic thin film layer and the organic compound layer, which are characteristic members.

### 1. Inorganic Thin Film Layer

The inorganic thin film layer of the present invention functions as a layer for injecting holes, and functions for improving the adhesion between the organic layer and the anode.

The inorganic thin film layer is insulating or semiconductive.

The term "insulating" means that when a material is formed as a thin film, the film has a resistivity of 10⁹ Ω·cm or more, and the term "semiconductive" means that the film has a resistivity of 10⁻² to 10⁹ Ω·cm.

In the case that the inorganic thin film layer is not insulating or semiconductive, triplets generated in the organic emitting layer are inactivated. Thus, the efficiency of the element falls.

The inorganic thin film layer of the present invention has an energy gap of 2.7 eV or more. If the energy gap is less than 2.7 eV, the layer has no electron barrier property. For this reason, its capability of causing electrons to remain in the emitting layer lowers, so that the efficiency lowers.

The wording "energy gap" is defined as the energy position of the absorption edge when the light absorption of the thin film of the inorganic thin film layer is measured. Usually, it is an energy position giving an OD (optical density) of 1/10 of the OD of the absorption peak.

In order to set the energy gap to 2.7 eV or more, compounds described below, which are transparent oxides, nitrides, carbides, oxynitrides and so on, and constitute the inorganic thin film layer, are appropriately selected.

The ionization potential of the inorganic thin film layer is preferably more than 5. 6 eV, more preferably 5.7 eV or more.

The inorganic thin film layer can be made of one or more selected from metals, and metal calcogenides, oxynitrides, carbides, nitrides, silicides and borides. The metal(s) may be a metal or metals in the following A group, or two or more metals wherein the A group is combined with the following B group or C group:
A group: In, Sn, Ga, Si, Ge, Zn, Cd, Mg, Al, Ta and Ti;
B group: metals having a work function of 4.5 eV or more; and
C group: Ce, Pr, Nd, Sm, Eu, Gd, Tb, Dy, Ho, Er, Tm, Yb, and Lu.

The combination of the A group with the B or C group makes it possible to yield an organic luminescence device which is superior in endurance and transparency and has a low driving voltage and a high luminance.

The inorganic thin film layer is preferably made of a calcogenide and a nitride of In, Sn, Ga, Si, Ge, Zn, Cd, Mg, Al, Ta or Ti since the layer is superior in transparency.

Specific examples of the inorganic compound comprising any one of the metals in the A group include SiOₓ (1 < x < 2), GeOₓ (1 < x < 2), TiOₓ (1 < x < 2), TaOₓ (1 < x < 1.5), SnO₂, In₂O₃, ZnO, GaO, CdO, MgO, SiN, GaN, ZnS, ZnSSe, MgSSe, andGaInN.

These inorganic compounds have a small absorption coefficient, a superior transparency, and a low light-quenching capability among the A group. Thus, the compounds can make large the amount of light that can be taken out. Of the calcogenides of Si, Ge, Sn, Zn, Ga, In, Cd and Mg, oxides thereof are preferable.

The inorganic compound is preferably made mainly of at least one oxide of In, Sn and Ga since voltage lost in the inorganic thin film layer as a semiconductive region can be made small.

Particularly preferable are an oxide or oxides of Si and/or Ge. In (Si₁₋ₓGeₓ)O_{y}, preferably 0 < x < 1 and 1.7 < y < 2.2, more preferably 1.7 < y ≤ 1.99, in particular preferably 1.85 ≤ y ≤ 1.98.

By making the oxide (s) so as to have the composition in the above-mentioned range, holes can be effectively injected from the hole injecting electrode to the organic compound layer on the light emitting layer side. If y is 2.2 or more or 1.7 or less, the hole injecting property falls so that the luminance lowers.

The main component may be silicon oxide or germanium oxide, or may be a mixed thin film thereof. The composition can be examined by, for example, Rutherfold backscattering, chemical analysis or the like.

It is preferred to use two or more out of oxides, oxynitrides, carbides and nitrides of In, Sn, Ga, Si, Al, Ta, Ti, Ge, Zn, Cd and Mg so as to constitute the inorganic thin film layer since the non-crystallinity is heightened and the surface becomes flat.

It is advisable that the inorganic thin film layer is made to contain a metal or compound having a work function of 4.5 eV or more. It is preferred that the inorganic thin film layer contains the metal or compound, which has a work function of 4.5 eV or more, or contains metals not only in the B group but also in the A group since the efficiency of injecting electric charges is raised so as to reduce the voltage.

The metal or compound, which has a work function of 4.5 eV or more, is preferably an atom belonging to any one of the groups IIIB, IVB, VB, VIB and VIIB in the periodic table (long period type); or a compound thereof. Preferable are Au, Ni, Bi, Cr, Ir, Nb, Pt, W, Mo, Ta, Pd, Ru, Ce, V, Zr, Re and Co, and oxides, carbides, nitrides, silicides and borides thereof. These may be used alone or in combination.

Specific examples of the inorganic compound comprising any one of the metals in the B group include one or any combination of two or more out of RuOₓ, V₂O₅, MoO₃, Ir₂O₃, NiO₂, RhO₄, ReOₓ, CrO₃, Cr₂O₃, RhOₓ, MoOₓ, and VOₓ. Preferable examples thereof include oxides of Ru, Re, V, Mo, Pd and Ir, that is, RuOₓ, ReOₓ, V₂O₅, MoO₃, MoOₓ, PdOₓ, and IrOₓ (x: 0 to 4).

The C group includes rare earth metals of Ce, Pr, Nd, Sm, Eu, Gd, Tb, Dy, Ho, Er, Tm, Yb and Lu.

The compound comprising any one of the metals in the C group is preferably an oxide. Specific examples of the oxide include one or any combination of two or more out of CeO₂, CeOₓ, Ce₂O₃, Pr₂O₃, Pr₆O₁₁, Nd₂O₃, Sm₂O₃, EuO, EuOₓ, Eu₂O₃, Gd₂O₃, Tb₄O₇, Dy₂O₃, Ho₂O₃, Er₂O₃, Tm₂O₃, Yb₂O₃, and Lu₂O₃. Preferable are CeO₂, CeOₓ, Tb₄O₇ and Yb₂O₃.

By use of one or more of the metals in the B group or C group, an energy level capable of injecting electric charges to the organic compound layermore surely (middle level) is formed in the inorganic thin film layer so that the injection of the electric charges becomes satisfactory.

This energy level is preferred from the viewpoint of a reduction in the voltage since the level becomes a path for hole transportation in the inorganic thin film layer also.

The content of one or more of the metals in the B group or C group is varied in accordance with the kind thereof. When the total amount of the inorganic thin film layer is determined to be 100 at.%, the content thereof is preferably from 0.1 to 50 at.%, more preferably from 1 to 30 at.%, even more preferably from 2 to 20 at.% since a good balance is attained between the transparency, the easiness of the formation of the middle level in the inorganic thin film layer, and others.

If the content is less than 0.1 at.%, no middle level may be formed in the inorganic thin film layer. If the content is more than 50 at.%, the inside of the inorganic thin film layer may be colored or the transparency (light transmittance) thereof may fall.

The inorganic thin film layer of the present invention can be made of one or more metals or compounds selected from one or more metals selected from the C group and calcogenides, oxynitrides, carbides, nitrides, silicides and borides of the metals. The inorganic thin film layer can be preferably made mainly of at least one oxide selected from oxides of Ce, Pr, Nd, Sm, Eu, Gd, Tb, Dy, Ho, Er, Tm, Yb, and Lu. Specific examples and preferable examples of these oxides (the C group oxides) are as described above.

The thickness of the inorganic thin film layer is not particularly limited, and is preferably from 0.5 to 100 nm. The thickness is more preferably from 0.5 to 50 nm, even more preferably from 0. 5 to 5 nm since the balance between endurance, driving voltage value and others becomes good. If the thickness is less than 0.5 nm, the use thereof for a long term may cause pinholes so that a leakage current may be observed. If the thickness is more than 100 nm, the driving voltage may become high or the luminance may fall.

The method for forming the inorganic thin film layer is not particularly limited. For example, such a method as CVD, sputtering or deposition may be adopted. It is particularly preferable to adopt sputtering.

In the case that the layer is formed by sputtering, the pressure of the sputtering gas is preferably from 0.1 to 1 Pa at the time of the sputtering. The sputtering gas may be an inert gas used in ordinary sputtering machines, for instance, Ar, Ne, Xe or Kr. If necessary, N₂ may be used. As the atmosphere at the time of the sputtering, O₂ may be mixed with the above-mentioned sputtering gas in an amount of about 1 to 99%, and reactive sputtering may be conducted therein.

A high-frequency sputtering using an RF power source, DC sputtering, or the like may be used as the sputtering. The electric power of the sputtering machine is preferably from 0.1 to 10 W/cm² for RF sputtering. The film-forming rate is preferably from 0. 5 to 10 nm/min., in particular preferably from 1 to 5 nm/min.

The substrate temperature at the time of the sputtering is about from room temperature (25) to about 150°C. The sputtering is preferably conducted at a vacuum degree of 1 × 10⁻⁷ to 1 × 10⁻³ Pa, a film-forming rate of 0.01 to 50 nm/second and a substrate temperature of -50 to 300°C in an inert gas.

If necessary, the inorganic thin film layer can contain Hf, Sc, Y, La, Rh, Os, Ag, Ca, Fe, Mn, Cu, Sb, As, Se, Tl, Pb or some other element, besides the above-mentioned A, B and/or C group metal (s) or compound (s), as long as the properties thereof are not damaged.

### 2. Organic Compound Layer

The organic compound layer is made of one or more layers which comprise at least an organic emitting layer. The organic emitting layer and/or the other organic layer(s) can comprise an ortho-metallized metal complex. The inclusion of the ortho-metallized metal complex in the organic layer makes it possible to use triplet-state excitons, so that the organic layer exhibits a high luminance and a high luminescence efficiency

### (1) Ortho-Metallized Metal Complex

The ortho-metallized metal complex used in the present invention is a generic name of the group of compounds described in, for instance, "Organic Metal Chemistry -Foundation and Application thereof-", p.150, 232, Shokabo Publishing Co., Ltd., written by Akio Yamamoto and published in 1982, and "Photochemistry and Photophysics of Coordination Compounds", pp. 71-77, and pp. 135-146, Springer-Verlang Co, written by Yersin and published in 1987.

The center metal of the metal complex may be any transition metal. In the present invention, in particular, rhodium, platinum, gold, iridium, ruthenium, palladium and so on can be preferably used. Of these, particularly preferable is iridium.

The valence of the metal of the ortho-metallized metal complex is not particularly limited. In the case that iridium is used, iridium is preferably trivalent. The ligand of the ortho-metallized metal complex is not limited to any especial kind if the ligand makes the formation of the ortho-metallized metal complex possible. Examples thereof include aryl-substituted nitrogen-containing heterocyclic derivatives (the substitution position of the aryl group is on a carbon adjacent to the nitrogen atom of the nitrogen-containing heteroring; examples of the aryl group include phenyl, naphthyl, anthracenyl and pyrenyl groups; and examples of the nitrogen-containing heteroring include pyridine, pyrimidine, pyrazine, pyridazine, quinoline, isoquinoline, quinoxaline, phthalazine, quinazoline, naphthridine, cinnoline, perimidine, phenanthroline, pyrrole, imidazole, pyrazole, oxazole, oxadiazole, triazole, thiadiazole, benzimidazole, benzoxazole, benzthiazole, and phenanthridine); heteroaryl-substituted nitrogen-containing heterocyclic derivatives (the substitution position of the heteroaryl group is on a carbon adjacent to the nitrogen atom of the nitrogen-containing heteroring; and examples of the heteroaryl group include groups containing the above-mentioned nitrogen-containing heterocyclic derivatives, and thiophenyl and furyl groups); 7,8-benzoquinoline derivatives, phosphinoaryl derivatives, phosphinoheteroaryl derivatives, phosphinoxyaryl derivatives, phosphinoxyheteroaryl derivatives, aminomethylaryl derivatives, and aminomethylheteroaryl derivatives. Preferable are aryl-substituted nitrogen-containing aromatic heterocyclic derivatives, heteroaryl-substituted nitrogen-containing aromatic heterocyclic derivatives, and 7,8-benzoquinoline derivatives. More preferable are phenylpyridine derivatives, thiophenylpyridine derivatives, and 7,8-benzoquinoline derivatives. Particularly preferable are thiophenylpyridine derivatives, and 7,8-benzoquinoline derivatives.

The ortho-metallized metal complex may have a ligand different from the ligand necessary for forming the ortho-metallized metal complex. Examples of the different ligand may be various known ligands, and include ligands described in "Photochemistry and Photophysics of Coordination Compounds", Springer-Verlag Co., written by H. Yersin and published in 1987; "Organic Metal Chemistry -Foundation and Application thereof-", Shokabo Publishing Co., Ltd., written by Akio Yamamoto and published in 1982. Preferable are halogen ligands (preferably, a chlorine ligand), nitrogen-containing heterocyclic ligands (such as bipyridyl, and phenanthroline), and diketone ligands. More preferable are a chlorine ligand and a bipyridyl ligand.

The ligands which the ortho-metallized metal complex has may be of a single kind or plural kinds. The number of the ligands in the complex is preferably 1 to 3 kinds, particularlypreferably 1 or 2 kinds, more preferably 1 kind.

The number of the carbon atoms in the ortho-metallized metal complex is preferably from 5 to 100, more preferably from 10 to 80, even more preferably from 14 to 50.

Preferred embodiments of the ortho-metallized metal complex are a compound having a partial structure represented by the following formula [1], or a tautomer thereof; a compound having a partial structure represented by the following formula [2], or a tautomer thereof; and a compound having a partial structure represented by the following formula [3], or a tautomer thereof.

Of these, particularly preferable are a compound having a partial structure represented by the following formula [1], or a tautomer thereof; and a compound having a partial structure represented by the following formula [2], or a tautomer thereof.

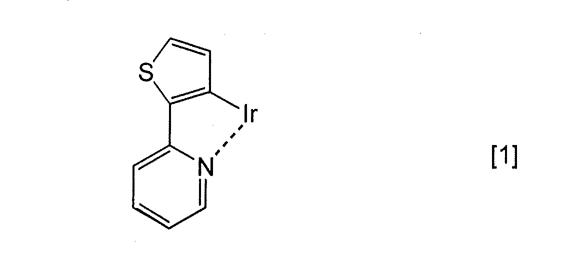

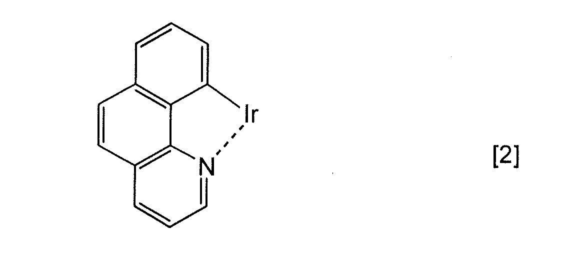

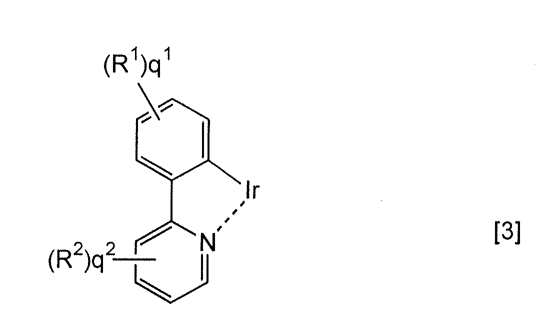

The compound having a partial structure represented by the formula [1], or the tautomer may have, in the compound, one iridium atom, may be the so-called multi-nuclei complex having two or more iridium atoms, or may contain a different metal atom together. The same is applied for the compound having a partial structure represented by the formula [2] or [3], or the tautomer thereof.

R¹ and R² in the formula [3] each represent a substituent; q¹ and q² each represent an integer of 0 to 4; and q¹ + q² is 1 or more. In the case that q¹ and q² are each 2 or more, plural R¹'s, as well as R²'s, may be the same or different.

R¹ and R² are each, for example, alkyl groups (having preferably 1 to 30 carbon atoms, more preferably 1 to 20 carbon atoms, particularly preferably 1 to 10 carbon atoms, examples thereof including methyl, ethyl, iso-propyl, tert-butyl, n-octyl, n-decyl, n-hexadecyl, cyclopropyl, cyclopentyl, and cyclohexyl); alkenyl groups (having preferably 2 to 30 carbon atoms, more preferably 2 to 20 carbon atoms, particularly preferably 2 to 10 carbon atoms, examples thereof including vinyl, allyl, 2-butenyl, and 3-pentenyl); alkynyl groups (having preferably 2 to 30 carbon atoms, more preferably 2 to 20, particularly preferably 2 to 10 carbon atoms, examples thereof including propargyl, and 3-pentynyl); aryl groups (having preferably 6 to 30 carbon atoms, more preferably 6 to 20, particularly preferably 6 to 12, examples thereof including phenyl, p-methylphenyl, naphthyl, andanthranyl); amino groups (having preferably 0 to 30 carbon atoms, more preferably 0 to 20 carbon atoms, particularly preferably 0 to 10 carbon atoms, examples thereof including amino, methylamino, dimethylamino, diethylamino,dibenzylamino,diphenylamino,and ditolylamino); alkoxy groups (having preferably 1 to 30 carbon atoms, more preferably 1 to 20 carbon atoms, particularly preferably 1 to 10 carbon atoms, examples thereof including methoxy, ethoxy, butoxy, and 2-ethylhexyloxy); aryloxy groups (having preferably 6 to 30 carbon atoms, more preferably 6 to 20 carbon atoms, particularly preferably 6 to 12, examples thereof including phenyloxy, 1-naphthyloxy, and 2-naphthyloxy);
heteroaryloxy groups (having preferably 1 to 30 carbon atoms, more preferably 1 to 20 carbon atoms, particularly preferably 1 to 12 carbon atoms, examples thereof including pyridyloxy, pyrazyloxy, pyrimidyloxy, and quinolyloxy); acyl groups (having preferably 1 to 30 carbon atoms, more preferably 1 to 20 carbon atoms, particularly preferably 1 to 12 carbon atoms, examples thereof including acetyl, benzoyl, formyl, and pivaloyl); alkoxycarbonyl groups (having preferably 2 to 30 carbon atoms, more preferably 2 to 20 carbon atoms, particularly preferably 2 to 12 carbon atoms, examples thereof including methoxycarbonyl and ethoxycarbonyl); aryloxycarbonyl groups (having preferably 7 to 30 carbon atoms, more preferably 7 to 20 carbon atoms, particularly preferably 7 to 12 carbon atoms, examples thereof including phenyloxycarbonyl); acyloxy groups (having preferably 2 to 30 carbon atoms, more preferably 2 to 20 carbon atoms, particularly preferably 2 to 10 carbon atoms, examples thereof including acetoxy, and benzoyloxy) ; acylamino groups (having preferably 2 to 30, more preferably 2 to 20, particularly preferably 2 to 10 carbon atoms, examples thereof including acetylamino, and benzoylamino); alkoxycarbonylamino groups (having preferably 2 to 30 carbon atoms, more preferably 2 to 20 carbon atoms, particularly preferably 2 to 12 carbon atoms, examples thereof including methoxycarbonylamino); aryloxycarbonylamino groups (having preferably 7 to 30 carbon atoms, more preferably 7 to 20 carbon atoms, particularly preferably 7 to 12 carbon atoms, examples thereof including phenyloxycarbonylamino);
sulfonylamino groups (having preferably 1 to 30 carbon atoms, more preferably 1 to 20 carbon atoms, particularly preferably 1 to 12 carbon atoms, examples thereof including methanesulfonylamino, and benzenesulfonylamino); sulfamoyl groups (having preferably 0 to 30 carbon atoms, more preferably 0 to 20 carbon atoms, particularly preferably 0 to 12 carbon atoms, examples thereof including sulfamoyl, methylsulfamoyl, dimethylsulfamoyl, and phenylsulfamoyl); carbamoyl groups (having preferably 1 to 30 carbon atoms, more preferably 1 to 20 carbon atoms, particularly preferably 1 to 12 carbon atoms, examples thereof including carbamoyl, methylcarbamoyl, diethylcarbamoyl, and phenylcarbamoyl); alkylthio groups (having preferably 1 to 30 carbon atoms, more preferably 1 to 20 carbon atoms, particularly preferably 1 to 12 carbon atoms, examples thereof includingmethylthio, andethylthio); arylthio groups (having preferably 6 to 30 carbon atoms, more preferably 6 to 20 carbon atoms, particularly preferably 6 to 12 carbon atoms, examples thereof including phenylthio); heteroarylthio groups (having preferably 1 to 30 carbon atoms, more preferably 1 to 20 carbon atoms, particularly preferably 1 to 12 carbon atoms, examples thereof including pyridylthio, 2-benzimidazolythio, 2-benzoxazoylthio, and 2-benzthiazolylthio); sulfonyl groups (having preferably 1 to 30 carbon atoms, more preferably 1 to 20 carbon atoms, particularly preferably 1 to 12 carbon atoms, examples thereof including mesyl and tosyl); sulfinyl groups (having preferably 1 to 30 carbon atoms, more preferably 1 to 20 carbon atoms, particularly preferably 1 to 12 carbon atoms, examples thereof including methanesulfinyl, and benzenesulfinyl);
ureido groups (having preferably 1 to 30 carbon atoms, more preferably 1 to 20 carbon atoms, particularly preferably 1 to 12 carbon atoms, examples thereof including ureido, methylureido, and phenylureido); phosphoric amide groups (having preferably 1 to 30 carbon atoms, more preferably 1 to 20 carbon atoms, particularly preferably 1 to 12 carbon atoms, examples thereof including diethylphosphoric amide, and phenylphosphoric amide); a hydroxyl group; a mercapto group; halogen atoms (such as fluorine, chlorine, bromine, and iodine atoms); a cyano group; a sulfo group; a carboxyl group; a nitro group; a hydroxamic acid group; a sulfino group; a hydrazino group; an imino group; heterocyclic groups (having preferably 1 to 30 carbon atoms, more preferably 1 to 12 carbon atoms, examples of the hetero atom therein including nitrogen, oxygen and sulfur atoms, and specific examples of the heterocyclic groups including imidazoyl, pyridyl, quinolyl, furyl thienyl, piperidyl, morpholino, benzoxazoyl, benzimidazoyl, and benzthiazoyl) ; and silyl groups (having preferably 3 to 40 carbon atoms, more preferably 3 to 30 carbon atoms, particularly preferably 3 to 24 carbon atoms, examples thereof including trimethylsiyl and triphenylsiyl). These substituentsmaybe further substituted. R¹ groups, R² groups, or R¹ and R² groups may be bonded to each other to form a condensed ring structure.

Preferably, R¹ and R² are each an alkyl, aryl, alkoxy group or a group which can be bonded to form a condensed ring structure. More preferably, R¹ and R² are each an alkyl group or a group which can be bonded to form an aromatic condensed ring structure. Preferably, q¹ and q² are each 0, 1 or 2. More preferably, q¹ + q² is 1 or 2.

More preferable embodiments of the ortho-metalli zed metal complex used in the present invention are compounds represented by the formula [4], compounds represented by the formula [5], and compounds represented by the formula [6]. Of these, particularly preferable are compounds represented by the formula [4] and compounds represented by the formula [5].

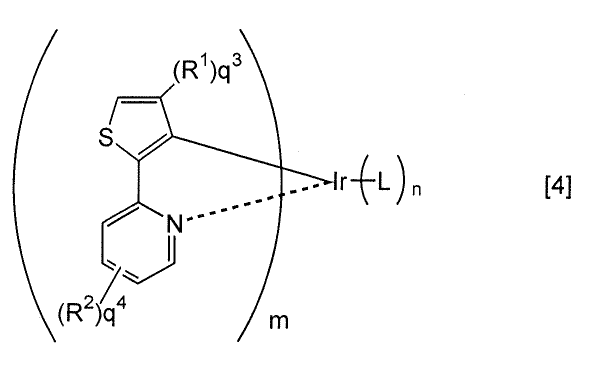

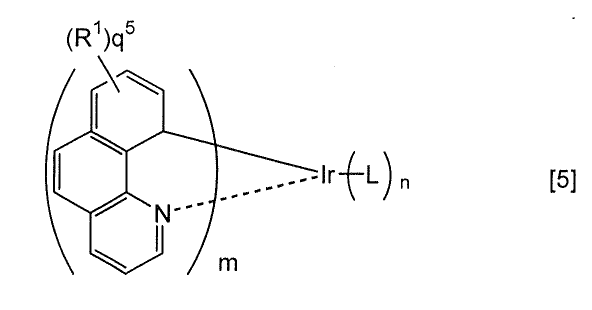

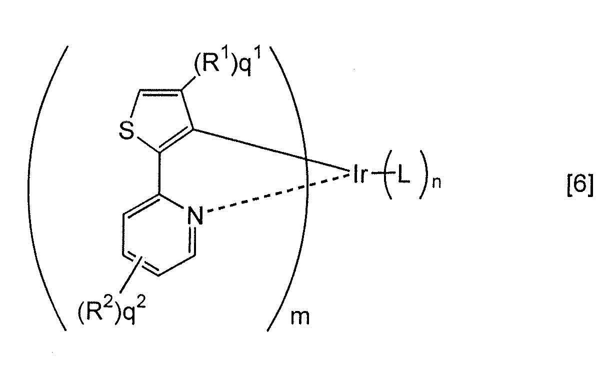

In the formula [4], R¹ and R² are as described above, and are each preferably an alkyl or aryl group, more preferably an alkyl group. q³ represents an integer of 0 to 2, preferably 0 or 1, more preferably 0. q⁴ represents an integer of 0 to 4, preferably 0 or 1, more preferably 0. When q³ and q⁴ are each 2 or more, plural R¹'s, as well as plural R²'s, may be the same or different, or may be bonded to each other to form a condensed ring.

L represents a ligand. Examples of L include ligands necessary for forming the ortho-metallized iridium complex, and the same ligands as those described about the different ligands. L is preferably a ligand necessary for forming the ortho-metallized iridium complex, a nitrogen-containing heterocyclic ligand, a diketone ligand, or a halogen ligand, and is more preferably a ligand necessary for forming the ortho-metallized iridium complex or a bipyridiyl ligand. n represents an integer of 0 to 5, and is preferably 0. m represents 1, 2 or 3, and is preferably 3. The combination of the numbers n and m is preferably a combination of numbers which permits the metal complex represented by the formula [4] to be a neutral complex.

In the formula [5], R¹, L, n, and m are as described above. q⁵ is an integer of 0 to 8, and is preferably 0. When q⁵ is 2 or more, plural R¹'s may be the same or different or be bonded to each other to form a condensed ring.

In the formula [6], R¹, R², q¹, q², L, n and m are as described above.

The ortho-metallized metal complex may be the so-called low molecular weight compound which has one recurring unit of the formula [1] or the like, or may be the so-called oligomer compound or polymer compound which has plural recurring units of the formula [1] and the like (the average molecular weight (relative to standard polystyrene: Mw) thereof is preferably from 1,000 to 5,000, 000, more preferably from 2,000 to 1,000,000, even more preferably from 3,000 to 100,000). The compound used in the invention is preferably a low molecular weight compound.

The added amount of the ortho-metallized metal complex in the organic compound layer can be selected within a wide range, and is from 0.1 to 99% by weight, preferably from 1 to 20% by weight. It is preferable to use the ortho-metallized metal complex in the organic emitting layer, and it is also preferable to use the ortho-metallized metal complex, as a dopant, together with a host material.

The emitting layer may be made mainly of the ortho-metallized metal complex.

### (2) Organic Emitting Layer

The organic emitting layer is composed of a host material, a dopant and so on.

The host material is a material for transporting electric charges of electrons and/or holes, and is preferably a carbazole derivative, a compound having a condensed heteroring skeleton having a nitrogen atom at the condensed moiety thereof, and so on.

The host material is preferably a polymer compound. If the host material is the polymer compound, the compound can be dissolved in a solvent to apply the resultant into the form of a film.

The carbazole derivative is a monomer containing carbazole, an oligomer, such as a dimer or trimer, containing carbazole, or a polymer material having a carbazole group.

Examples thereof may be carbazole compounds represented by the following formula [7]: 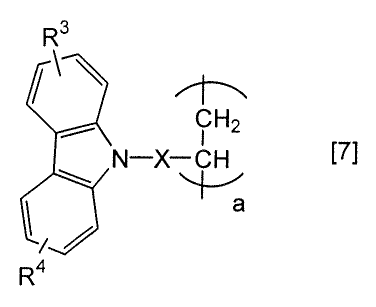 wherein R³ and R⁴ each represent hydrogen, or an alkyl group having 1 to 18 carbon atoms; X represents a linking group, preferably 1 to 3 rings of a phenyl group, or an alkylene group; and a represents recurring. The molecular weight, Mw, of the compound represented by the formula [7] is preferably from 10, 000 to 100,000. R³ and R⁴ may further have a substituent.

Some polymer compounds each having in the main chain thereof a carbazole group are also preferable. The carbazole derivative may be a carbazole compound represented by the following formula [8]: 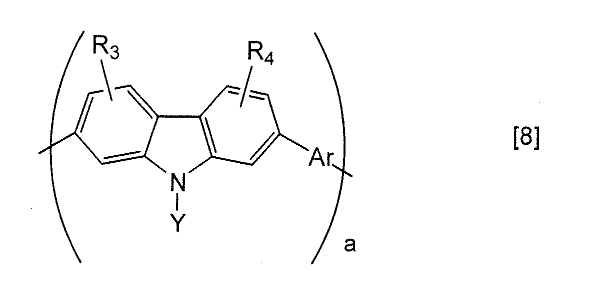 wherein R³, R⁴ and a are as described above; Y represents an aryl, alkylene or xylylene group; and Ar represents 1 to 4 rings of a phenyl group and is particularly preferably a phenylene, anthracenediyl, or naphthacenediyl derivative. R³, R⁴, Y and Ar may further have a substituent. The aryl group represented by X or Ar is particularly preferably a monocyclic biphenyl group.

Preferable are polymer materials each having, in a side chain thereof, a carbazole group. Specifically, preferable is polyvinylcarbazole represented by the following formula [9]: 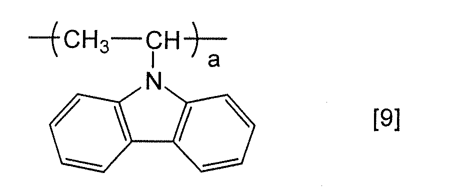 wherein a is as described above.

The compound having a condensed heteroring skeleton having a nitrogen atom at the condensed moiety thereof is preferably a compound represented by the following formula [10]: 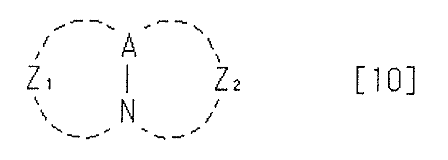 wherein A represents a carbon atom or nitrogen atom; and Z₁ and Z₂ independently represent an atomic group capable of forming a nitrogen-containing heteroring.

The heteroring compound is a compound having a condensed heteroring skeleton having a nitrogen atom at the condensed moiety thereof. The compound used in the present invention is preferably a compound which has one or more atoms selected from N, O and S atoms besides the nitrogen atom at the condensed moiety, and is more preferably an aromatic heteroring having two or more nitrogen atoms in the whole of the skeleton, particularly preferably an aromatic heteroring having one N atom at the condensed moiety and further having another nitrogen atom at a position that is not the condensed moiety in the aromatic heteroring. Each of the rings in the condensed heteroring is preferably from 3- to 8-membered, preferably from 5- to 6-membered.

Examples of the skeleton of the heteroring used in the invention include indolizine, pyrroimidazole, pyrrolotriazole, pyrazoloimidazole, pyrazolotriazole, pyrazolopyrimidine, pyrazolotriazine, imidazoimidazole, imidazopyridazine, imidazopyridine, imidazopyrazine, and triazolopyridine. Preferable are imidazopyridazine, imidazopyridine, imidazopyrazine, and triazolopyridine.

A condensed heteroring as described above may be formed. This condensed ring may be substituted with various substituents other than a hydrogen atom.

Specific examples of the compound are illustrated below.

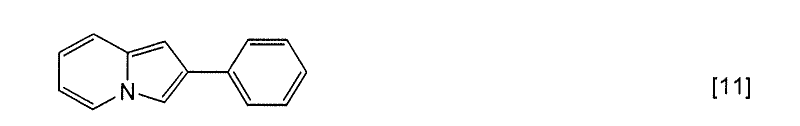

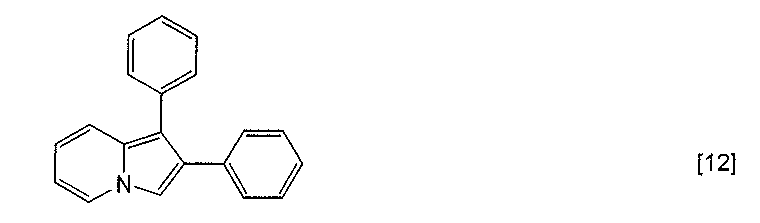

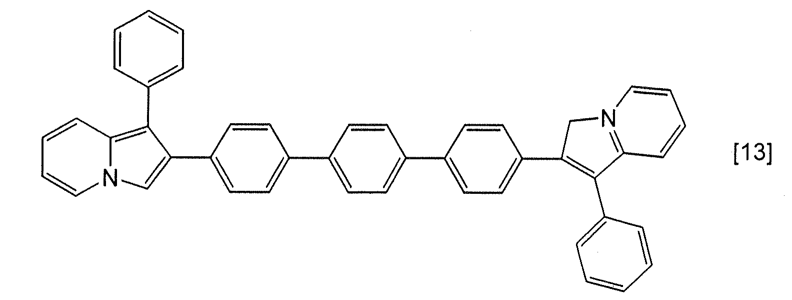

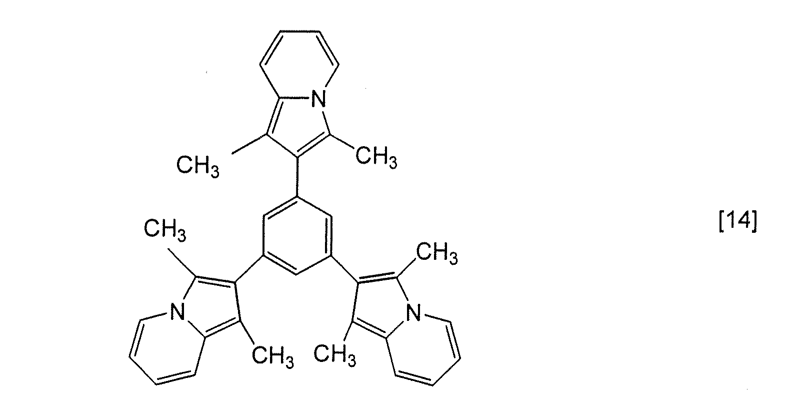

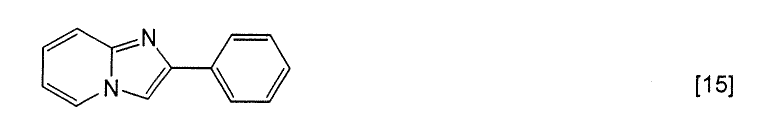

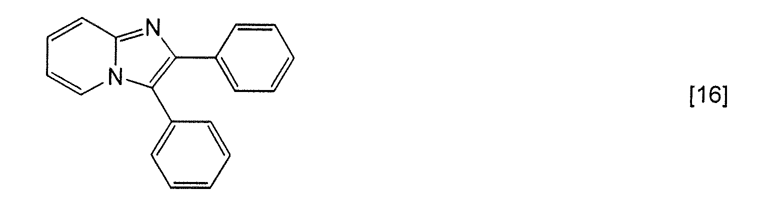

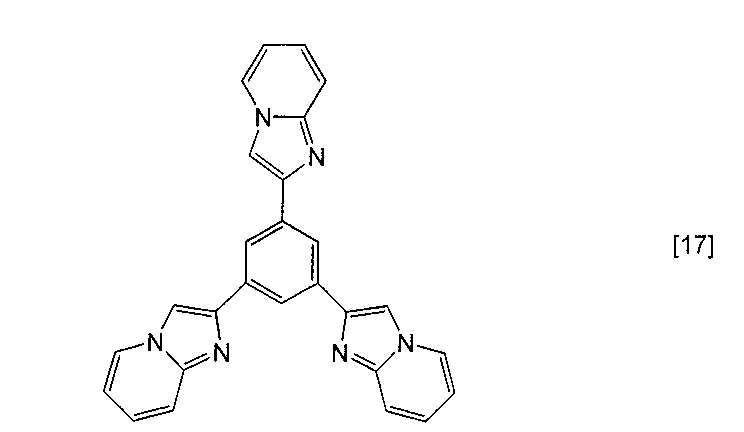

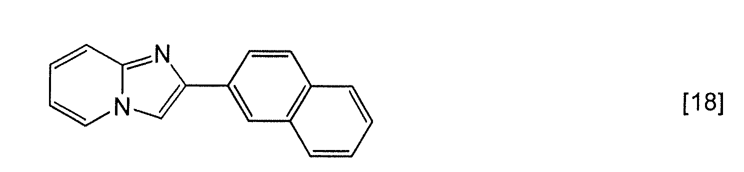

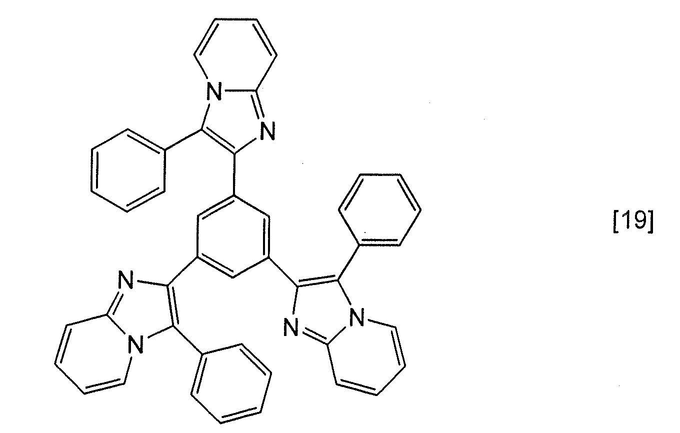

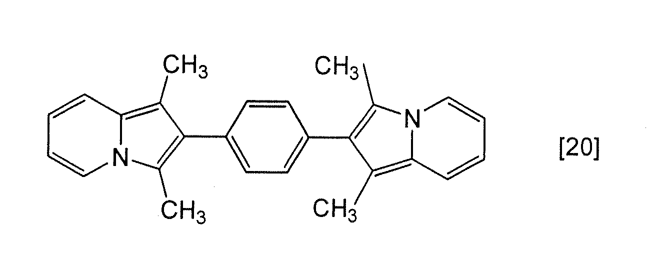

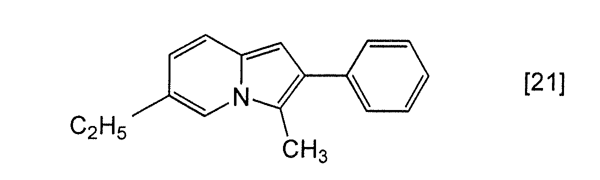

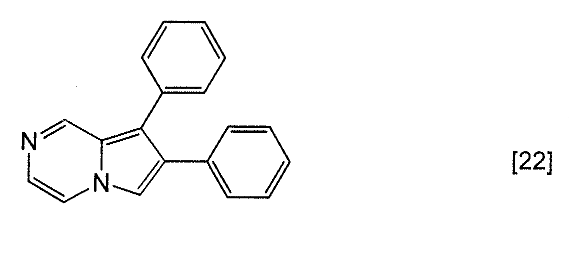

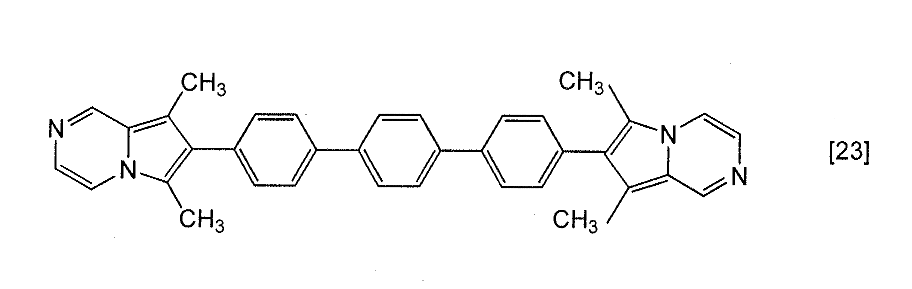

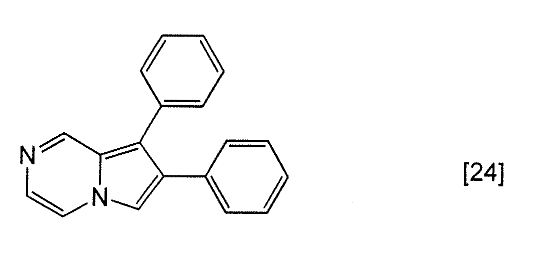

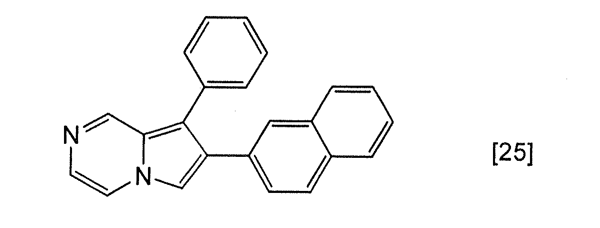

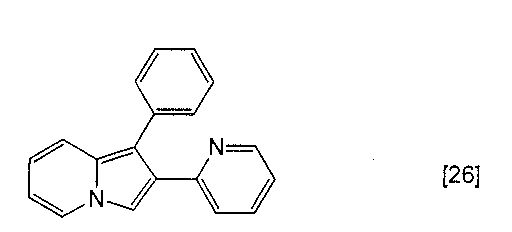

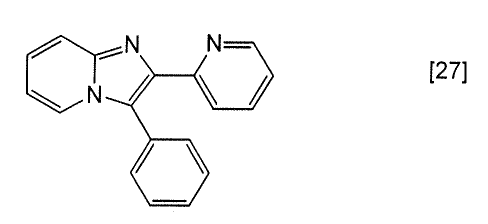

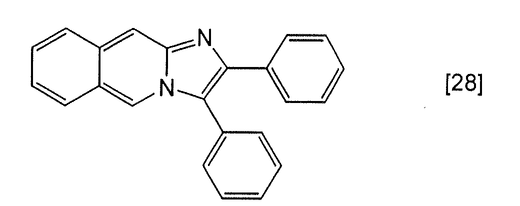

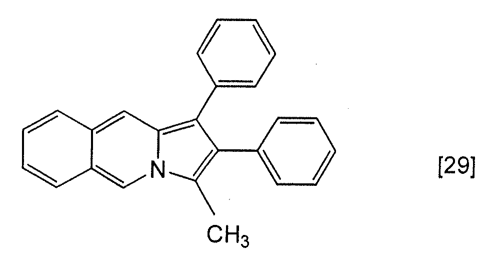

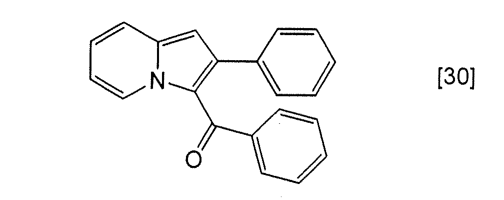

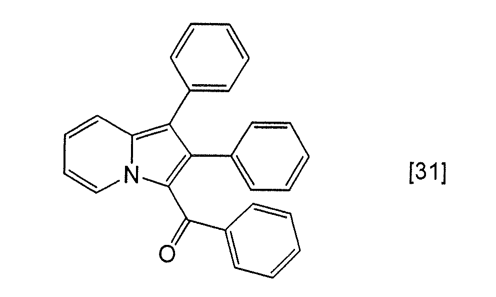

Furthermore, the heterocyclic compound represented by the formula [10] may form a polymer compound having its structure as a part of its recurring units. In this case, the polymer may be formed by polymerizing polymerizable groups, such as ethylenic unsaturated bonds, contained in the substituents of Z₁ and Z₂, or polymerizable groups capable of causing polycondensation, such as carboxyl, amino and ester groups, contained therein. Alternately, a precursor of the heterocyclic compound represented by the formula [10] may be formed into a polymer while forming a heteroring skeleton of the formula [10].

Specific examples of the polymer compound are illustrated below.

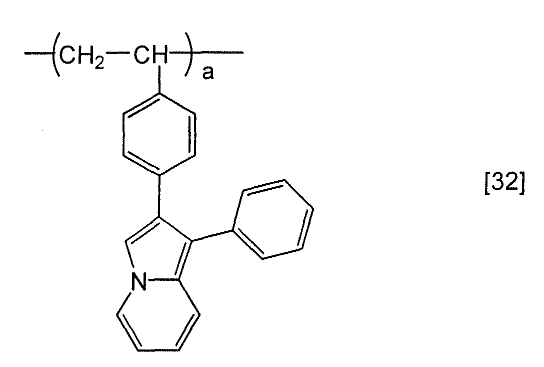

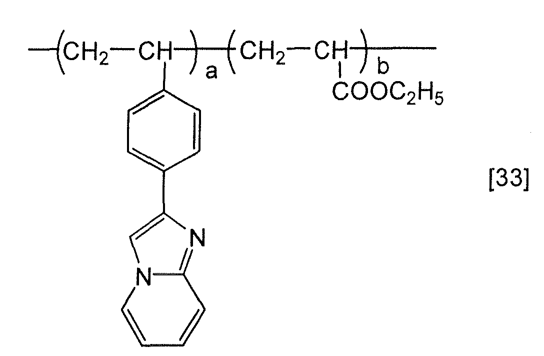

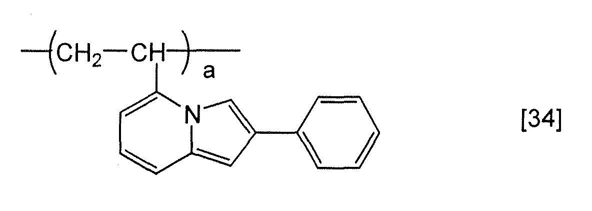

In the formulae [32] [33] and [34], a and b each represent recurring.

Whether the heterocyclic compound represented by the formula [10] is a low molecular weight compound or a polymer, the compound, which has a structure capable of expressing functions finally, can be used as it is. Alternately, it is allowable that a precursor thereof is used in an organic electroluminescence element, and after or during the formation of the element the precursor is subjected to physical or chemical post-treatment to become a final structure.

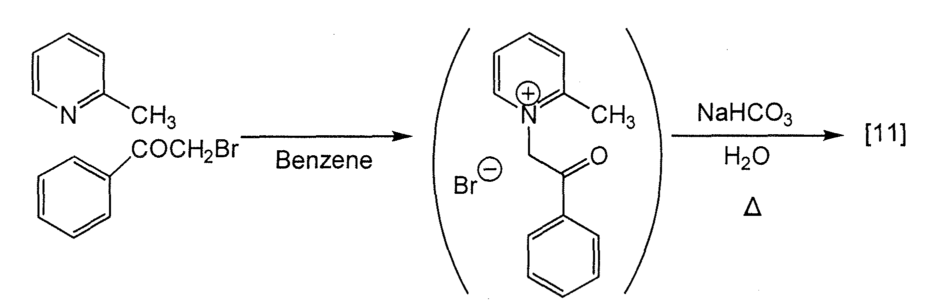

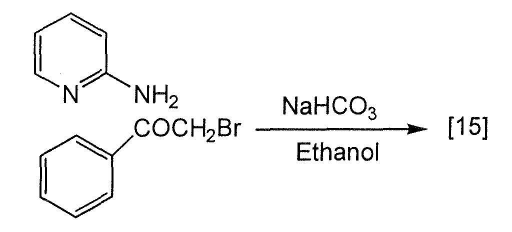

The energy gap of such an organic host material is preferably from 2.7 to 3.6 or more.

As the dopant, a generally known fluorescent dopant can be used together. For example, in the case that an emitting layer composed of two organic layers is used, one of the organic layers may be doped with the ortho-metallized metal complex and the other may be doped with the fluorescent dopant. The same organic layer may be doped with the ortho-metallized metal complex and the fluorescent dopant.

### (3) Other Organic Layers

### [1] Hole Transporting Layer

The following can be used as the hole transporting material used in the hole transporting layer: poly-N-vinylcarbazole derivatives, polyphenylenevinylene derivatives, polyphenylene, polythiophene, polymethylphenylsilane, polyaniline, triazole derivatives, oxadiazole derivatives, imidazole derivatives, polyarylalkane derivatives, pyrazoline derivatives and pyrazolone derivatives, phenylenediamine derivatives, arylamine derivatives,amino-substituted chalcone derivatives, oxazole derivatives, carbazole derivatives, styrylanthracene derivatives, fluorenone derivatives, hydrazone derivatives, stylbene derivatives, porphyrin derivatives (phthalocyanine and so on), aromatic tertiary amine compounds and styrylamine compounds, butadiene compounds, benzidine derivatives, polystyrene derivatives, triphenylmethane derivatives, tetraphenylbenzene derivatives, star-burst polyamine derivatives, and so on.

### [2] Electron Transporting Layer

Examples of the electron transporting material used in the electron transporting layer include oxadiazole derivatives, triazole derivatives, triazine derivatives, nitro-substituted fluorenone derivatives, thiopyrandioxide derivatives, diphenylquinone derivatives, perylenetetracarboxyl derivatives, anthraquinodimethane derivatives, fluorenylidenemethane derivatives, anthrone derivatives, perynone derivatives, oxine derivatives, and quinoline complex derivatives.

### [3] Electroconductive Polymer Layer

The formation of an electroconductive polymer layer makes it possible to increase the film thickness of the organic compound layer without raising driving voltage substantially and restrain the generation of luminance evenness or a short circuit.

Preferable examples of the electroconductive polymer which constitutes the electroconductive polymer layer include polyaniline derivatives, polythiophene derivatives and polypyrrole derivatives described in WO 98/05187 and so on. These may be used in the state that they are mixed with a proton acid (such as camphorsulfonic acid, p-toluenesulfonic acid, styrenesulfonic acid, or polystyrenesulfonic acid). If necessary, they may be used in the state that they are mixed withadifferentpolymer (suchaspolymethylmethacrylate (PMMA), or poly-N-vinylcarbazole (PVCz)).

The sheet resistance of the electroconductive polymer layer is preferably 10, 000 Ω/□ or less, and the film thickness is preferably from 10 to 1,000 nm, more preferably from 50 to 500 nm. The electroconductive polymer layer may contain a p-type inorganic semiconductor.

The position where the electroconductive polymer layer is formed is preferably between the anode and the inorganic compound.

### (4) Production of Organic Compound Layer

The respective organic layers may be formed by use of a known method such as vacuum deposition, sputtering, dipping, spin coating, casting, bar coating or roll coating. Multi-coating may be used by selecting plural solvents appropriately.

### 3. Other Constituent Members

### (1) Substrate

As the substrate, an ordinary glass substrate, plastic substrate or the like can be used. It is preferred that the plastic used as the substrate is superior in heat resistance, dimension stability, solvent resistance, electric non-conductance and workability, and is low in gas permeability and hygroscopicity.

Examples of such a plastic material include polyethylene terephthalate, polybutylene terephthalate, polyethylene naphthalene, polystyrene, polycarbonate, polyethersulfone, polyarylate, allyldiglycol carbonate, polyimide, and polycycloolefin.

It is preferred to form a moisture-permeation preventing layer (gas barrier layer) on the electrode side surface of the substrate, the surface thereof opposite to the electrode, or the two. The material which constitutes the moisture-permeation preventing layer is preferably an inorganic material such as silicon nitride, silicon oxide, silicon oxynitride, or non-alkali glass. The moisture-permeation preventing layer can be formed by high-frequency sputtering or the like. If necessary, a hard coat layer or an undercoat layer may be formed.

### (2) Electrodes

As the material of the anode used in the present invention, a known material such as tin oxide, ITO (indium tin oxide), or IZO (indium zinc oxide) may be used. A thin film of a metal having a large work function, such as gold or platinum, can also be used. Organic materials such as polyaniline, polythiophene, polypyrrole, and derivatives thereof can be used. A transparent conductive film described in detail in "New Development of Transparent Conductive Film" (supervised by Yutaka Sawada, published by CMC Publishing Co., Ltd. in 1999) and so on can also be used in the invention. The use of ITO or IZO is preferred particularly for the case that the electrode film is formed at low temperatures of 150°C or lower. Such low-temperature film formation is important when a plastic substrate low in heat resistance is used.

It is preferred from the viewpoint of electron injecting property to use, as the material of the cathode, an alkali metal such as Li, K or Ce or an alkaline earth metal such as Mg or Ca, which has a low work function. Al, which is not easily oxidized to be stable, or the like is also preferred. In order to make stability and electron injecting property compatible with each other, a layer containing two or more materials may be used. Such materials are described in detail in JP-A-2-15595 and JP-A-5-121172. Particularly preferable is aluminum alone or an alloy or mixture which mainly comprises Al and comprises 0. 01 to 10% by weight of an alkali metal or alkaline earth metal.

The anode and the cathode can be formed by a known method such as vacuum deposition, sputtering, or ion plating. The patterning of the electrodes is preferably performed by chemical etching such as photolithography, physical etching using a laser, or some other method. The patterning may be performed by vacuum deposition, sputtering or the like with a mask being placed.

### (3) Electron Injecting Layer

In the present invention, it is preferred to form an insulator thin film as an electron injecting layer between the cathode or the organic emitting layer or electron transporting layer. It is preferred to use, as the insulator thin film, a known thin film which has a thickness of about 0.01 to 10 nm and is made of aluminum oxide, lithium fluoride, cesium fluoride or the like.

### (4) Sealing Layer

In general, a sealing layer is fitted to the outside of the organic luminescence device to prevent the invasion of water or oxygen. The following can be used as the sealing material which constitutes the sealing layer: copolymers of tetrafluoroethylene and at least one comononer, fluorine-containing copolymers having a cyclic structure in the copolymer main chain thereof, polyethylene, polypropylene, polymethyl methacrylate, polyimide, polyurea, polytetrafluoroethylene, polychlorotrifluoroethylene, polydichlorodifluoroethylene, copolymers of chlorotrifluoroethylene and dichlorodifluoroethylene, mixtures of a water-absorptive material having a water absorption of 1% or more and a moisture-proofing material having a water absorption of 0.1% or less, metals (such as In, Sn, Pb, Au, Cu, Ag, Al, Ti and Ni), metal oxides (MgO, SiO, SiO₂, Al₂O₃, GeO, NiO, CaO, BaO, Fe₂O₃, Y₂O₃, and TiO₂), metal fluorides (such as MgF₂, LiF, AlF₃, and CaF₂), liquid fluorinated carbons (such as perfluoroalkane, perfluoroamine, and perfluoroether), and materials wherein an adsorbent for adsorbing water or oxygen is dispersed in the liquid fluorinated carbons.

The organic luminescence device of the present invention emits light by applying a DC voltage (which may contain an alternate component, which is usually a pulse voltage of 2 to 30 V) or a pulse current to its anode and cathode across them. A driving method described in the following can be used: JP-A-2-148687, JP-A-6-301355, JP-A-5-29080, JP-A-7-134558, JP-A-8-234685 and JP-A-8-241047.

The organic luminescence device of the present invention contains, in its organic compound layer, the specific inorganic thin film layer and ortho-metallized metal complex, thereby having an improved luminescence efficiency and a high luminance. The lifespan of the element is also improved since the element can be driven at a low applying voltage.

Specifically, therefore, the element can be expected to be used in articles such as displays, backlights for LCD, light sources for illumination, light sources for optical communication, and reading and writing heads for information files.

### [Examples]

Examples of the present invention are described hereinafter, but the invention is not limited by these examples.

Elements produced in the respective examples were evaluated by the following methods.
(1) Luminance: it was measured with a spectral radiance meter (CS-1000, manufactured by Minolta).
(2) Efficiency: it was calculated from the current density value and the luminance measured with a multimeter.
(3) Half life: in Examples 1 to 4 and Comparative Examples 1 to 3, the measurement thereof was made about each sealed element at an initial luminance of 500 nit under constant current conditions. In Examples 6 to 8 and Comparative Example 7, the measurement was made about each sealed element at an initial luminance of 1000 nit under constant current conditions.

### Example 1

A transparent electrode film, 120 nm thick, made of ITO was formed as an anode layer on a transparent glass substrate 1.1 mm thick, 25 mm long and 75 mm wide. Hereinafter, this combination of the glass substrate and the anode layer is referred to as the substrate.

Subsequently, this substrate was subjected to ultrasonic washing in isopropyl alcohol, and further dried in a N₂ (nitrogen gas) atmosphere. Thereafter, the substrate was washed with UV (ultraviolet rays) and ozone for 10 minutes.

Next, the substrate was set inside a chamber of a sputtering machine, and further into the chamber was put a target composed of tin oxide and ruthenium oxide (composition: 10/1), which would constitute an inorganic thin film layer.

Furthermore, the inorganic thin film layer was formed in the sputtering machine. The sputtering was performed under the following conditions: a sputtering gas of Ar (30 sccm) and O₂ (5 sccm), a substrate temperature of 120°C, a film-forming rate of 1 nm/min., an operating pressure of 0.2 to 2 Pa, and an applied electric power of 300 W. In this way, the inorganic thin film layer was formed into a film thickness of 5 nm.

Next, the substrate was transported into a vacuum deposition machine. The substrate was fitted onto a substrate holder in a vacuum chamber of the vacuum deposition machine, and further the following were filled into deposition sources different from each other: a host material (formula [17]) constituting a part of an organic emitting layer; tris(2-phenylpyridine)iridium (Ir(ppy)₃), which was an ortho-metallized metal complex equally constituting a part of the organic emitting layer; bis(2-methyl-8-quinolilate)(P-phenylphenolate)aluminum (written as Balq hereinafter), which was an organic compound constituting an electron injecting layer; and a metal (Li) constituting a part of the electron injecting layer.

Next, the pressure inside the vacuum chamber was reduced to a vacuum degree of 3 × 10⁻⁷ Torr or less, and then the organic emitting layer, the electron injecting layer and a cathode layer were successively laminated onto the anode layer of the substrate and the inorganic thin film layer, so as to yield an organic EL device. In this case, the same vacuum conditions were used without breaking the vacuum state at any time from the formation of the organic emitting layer to the formation of the cathode layer.

The details of the film thicknesses, and weight ratio or atom ratio are as follows.
Emitting layer: the film thickness was 40 nm, and the weight ratio of the host material to the Ir(ppy)₃ was 93/7.
Electron injecting layer: Balq was used. The film thickness was 10 nm.
Electron injecting layer: Balq and Li were used. The film thickness was 10 nm. The atomic number ratio of Balq to Li was 1/1.
Cathode layer: Al was used.

### Example 2

An element was produced in the same way as in Example 1 except that GeO₂ was used as the target when the inorganic thin film layer was formed. A pellet of Au having a given size was arranged on this target to film a high-resistance inorganic hole injecting layer 7 nm thick.

The sputtering gas at this time was Ar (30 sccm) and O₂ (5 sccm). At room temperature (25°C), the film-forming rate, the operating pressure and the applying electric power were set to 1 nm/min., 0.2 to 2 Pa, and 500 W, respectively.

### Example 3

An element was produced in the same way as in Example 1 except that a target composed of Si oxide and Ir oxide (composition ratio: 10/1) was used when the inorganic thin film layer was formed. The inorganic thin film layer was formed into a film thickness of 7 nm.

The sputtering gas at this time was Ar (30 sccm) and O₂ (10 sccm). At room temperature, the film-forming rate, the operating pressure and the applying electric power were set to 1 nm/min., 0.2 to 2 Pa, and 400 W, respectively.

### Example 4

An element was produced in the same way as in Example 1 except that a target composed of Si oxide, In oxide and V oxide (composition ratio: 10/1/0.5) was used when the inorganic thin film layer was formed. The inorganic thin film layer was formed into a film thickness of 7 nm.

The sputtering gas at this time was Ar (30 sccm) and O₂ (10 sccm). At room temperature, the film-forming rate, the operating pressure and the applying electric power were set to 1 nm/min., 0.2 to 2 Pa, and 400 W, respectively.

### Comparative Example 1

An element was produced in the same way as in Example 1 except that no inorganic thin film layer was formed.

### Comparative Example 2

An element was produced in the same way as in Example 1 except that amorphous SiC having an energy gap of 2.0 eV was used in the inorganic thin film layer.

The amorphous SiC was formed by plasma CVD. SiH₄ and CH₄ diluted into 10% with hydrogen gas and B₂H₄ diluted into 500 ppm therewith were filled through mass flow controllers into the chamber, and then the pressure was kept at 1 Torr.

At this time, the gas flow amount ratio, B₂H₄/(SiH₄ + CH₄) was 0. 31%, and a high frequency of 13.56 MHz was applied thereto at 50W. A p-type a-SiC film having a thickness of 15 nm was formed onto the substrate having a substrate temperature of 190°C. Comparative Example 3

An element was produced in the same way as in Example 1 except that ZnTe having an energy gap of 2.3 eV was used in the inorganic thin film layer. ZnTe was formed by vacuum deposition, and the film thickness was 40 nm.

Table 1 shows the evaluation results of the elements produced in Examples 1 to 4 and Comparative Examples 1 to 3; and the energy gap values of the inorganic thin film layers obtained from the measurement of the light absorption thereof.

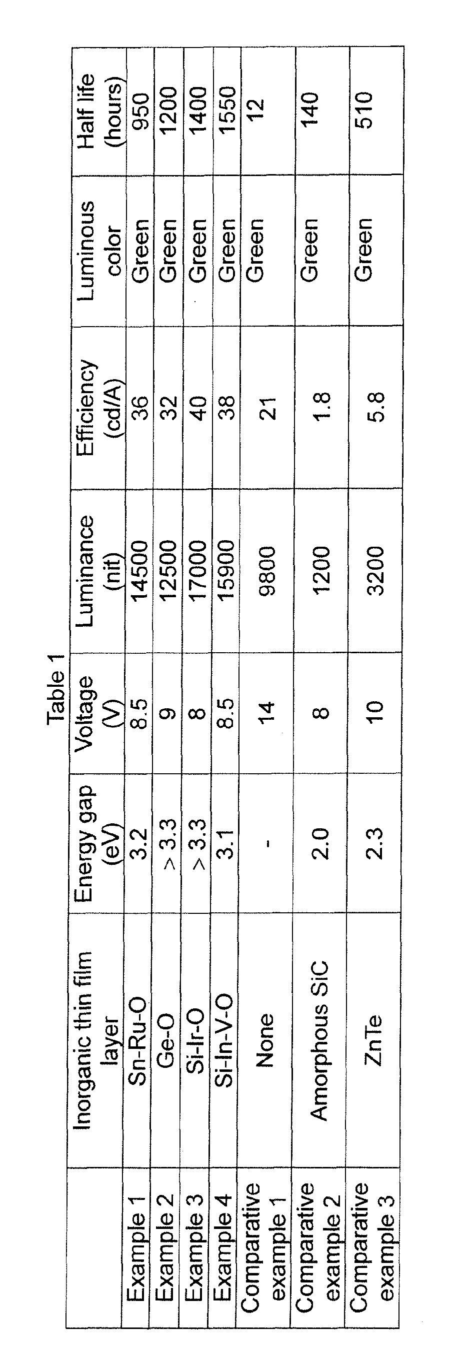

As described above, it was proved that the inorganic thin film layer was made of an insulating or semiconductive material of 2.7 eV or more, thereby exhibiting a high efficiency. On the other hand, when a semiconductor layer having a narrow energy gap was used, the efficiency was low on the basis of quenching. The lifespan thereof was also short. It was also proved that when no inorganic thin film layer was used, the voltage was high and the lifespan was short.

### Example 5

A transparent electrode film, 130 nm thick, made of IZnO (indium zinc oxide) was formed as an anode layer on a transparent glass substrate 1.1 mm thick, 25 mm long and 75 mm wide. Hereinafter, this combination of the glass substrate and the anode layer is referred to as the substrate.

Subsequently, this substrate was subjected to ultrasonic washing in isopropyl alcohol, and further dried in a N₂ (nitrogen gas) atmosphere. Thereafter, the substrate was washed with UV (ultraviolet rays) and ozone for 10 minutes.

Next, the substrate was set inside a chamber of a sputtering machine, and further into the chamber was put a target composed of silicon oxide and iridium oxide (composition: 10/1), which would constitute an inorganic thin film layer.

Furthermore, the inorganic thin film layer was formed in the sputtering machine. The sputtering was performed under the following conditions: a sputtering gas of Ar (30 sccm) and O₂ (5 sccm), a substrate temperature of 120°C, a film-forming rate of 1 nm/min., an operating pressure of 0.2 to 2 Pa, and an applied electric power of 300 W. In this way, the inorganic thin film layer was formed into a film thickness of 7 nm.

Next, a polymer emitting layer was formed on this substrate, on which the inorganic thin film layer was formed. A spin coater was used to apply thereto a coating solution obtained by dissolving polyvinyl carbazole (manufactured by Aldrich) as a host material and a tris(2-phenylpyridine)iridium complex as an ortho-metallized metal complex, at a weight ratio of 93/7, in dichloroethane. The resultant was vacuum-dried at 120°C for 2 hours to yield an emitting layer 70 nm thick.

Next, the substrate was fitted onto a substrate holder in a vacuum chamber of a vacuum deposition machine, and further an organic compound (Balq) constituting an electron injecting layer was filled into a deposition source and a metal (Li) constituting a part of the electron injecting layer was filled into another deposition source. AnAl cathode deposition source was also beforehand prepared in the vacuum-chamber.

Next, the pressure inside the vacuum chamber was reduced to a vacuum degree of 4 × 10⁻⁷ Torr or less, and then the electron injecting layer and a cathode layer were successively laminated onto the anode layer of the substrate, the inorganic thin film layer and the organic emitting layer, so as to yield an organic EL device. In this case, the same vacuum conditions were used without breaking the vacuum state at any time from the formation of the electron injecting layer to the formation of the cathode layer.

The details of the film thicknesses, and weight ratio or atom ratio were as follows.
Electron injecting layer: Balq was used. The film thickness was 10 nm.
Electron injecting layer: Balq and Li were used. The film thickness was 10 nm. The atomic number ratio of Balq to Li was 1/1.
Cathode layer: Al was used.

### Comparative Example 4

An element was produced in the same way as in Example 5 except that no inorganic thin film layer was formed.

### Comparative Example 5

An element was produced in the same way as in Example 5 except that amorphous SiC having an energy gap of 2.0 eV was used in the inorganic thin film layer.

As the amorphous SiC, the SiC formed in Comparative Example 2 was used.

The evaluation results of the elements produced in Example 5 and Comparative Examples 4 and 5 are shown in Table 2.

**Table 2**

| | Inorganic thin film layer | Voltage (V) | Luminance (nit) | Efficiency (cd/A) | Luminous Color |
|---|---|---|---|---|---|
| Example 5 | Si-Ir-O | 9.5 | 13000 | 28 | Green |
| Comparative example 4 | None | 18 | 10020 | 21 | Green |
| Comparative example 5 | Amorphous SiC | 10.0 | 1900 | 4.2 | Green |

It was made evident from Table 2 that the organic EL device of Example 5, wherein the constituent members other than the inorganic thin film layer of the Example 3 were changed, was able to be driven at a lower voltage, and exhibited a larger luminance and a higher efficiency than those of Comparative Examples 4 and 5.

### Example 6

A transparent electrode film, 100 nm thick, made of ITO was formed as an anode layer on a transparent glass substrate 1.1 mm thick, 25 mm long and 75 mm wide. Hereinafter, this combination of the glass substrate and the anode layer is referred to as the substrate.

Subsequently, this substrate was subjected to ultrasonic washing in isopropyl alcohol, and further dried in a N₂ (nitrogen gas) atmosphere. Thereafter, the substrate was washed with UV (ultraviolet rays) and ozone for 10 minutes.

Next, the substrate was set inside a chamber of a sputtering machine, and further into the chamber was put a target composed of iridium oxide, zinc oxide and cerium oxide (composition ratio = In₂O₃: 85% by weight, ZnO: 10% by weight, and CeO₂: 5% by weight), which would constitute an inorganic thin film layer.

Furthermore, the inorganic thin film layer was formed in the sputtering machine. The sputtering was performed under the following conditions: a sputtering gas of Ar (10 sccm), a substrate temperature of 200°C, a film-forming rate of 5 nm/min., a sputtering pressure of 0.1 Pa, and an applied electric power of 100 W. In this way, the inorganic thin film layer was formed into a film thickness of 20 nm. This inorganic thin film layer caused the injection of holes.

Next, the substrate was transported into a vacuum deposition machine. The substrate was fitted onto a substrate holder in a vacuum chamber of the vacuum deposition machine, and further the following were filled into deposition sources different from each other:
4,4'-bis(N-(1-naphthyl)-N-phenylamino)biphenyl (α-NPD) constituting a hole transporting layer; a host material, 4,4'-bis(carbazole-9-yl)-biphenyl (CBP) equally constituting a part of an organic emitting layer;
tris(2-phenylpyridine)iridium (Ir(ppy)₃), which was an ortho-metallized metal complex equally constituting a part of the organic emitting layer;
bis(2-methyl-8-quinolilate)(p-phenylphenolate)aluminum complex (written as BAlq hereinafter), which was an organic compound constituting an electron transporting layer (hole barrier layer); a tris(8-hydroxyquinoline)aluminum complex (written as Alq hereinafter), which was an organic compound constituting the electron transporting layer; and LiF constituting a part of an electron injecting layer.

Next, the pressure inside the vacuum chamber was reduced to a vacuum degree of 3 × 10⁻⁷ Torr or less, and then the hole injecting layer, the hole transporting layer, the organic emitting layer, the electron injecting layer and a cathode layer were successively laminated onto the anode layer of the substrate and the inorganic thin film layer, so as to yield an organic EL device. In this case, the same vacuum conditions were used without breaking the vacuum state at any time from the formation of the hole injecting layer to the formation of the cathode layer. The details of the film thicknesses, and weight ratio or atom ratio were as follows.
Hole transporting layer: α-NPD was used. The film thickness was 50 nm.
Emitting layer: CBP and Ir(ppy)₃ 40 nm, and the weight ratio of CBP to Ir(ppy)₃ was 93/7.
Electron transporting layer (hole barrier layer) : BAlq was used. The film thickness was 10 nm.
Electron injecting layer: Alq was used. The film thickness was 40 nm.
Electron injecting layer: LiF was used. The film thickness was 0.2 nm.
Cathode layer: Al was used.

### Example 7

An element was produced in the same way as in Example 6 except that into the chamber was fitted a target composed of indium oxide, zinc oxide and terbium oxide (composition ratio = In₂O₃: 85% by weight, ZnO: 10% by weight, and Tb₄O₇: 5% by weight) at the time of forming the inorganic thin film layer. The inorganic thin film layer was formed into a film thickness of 20 nm. This inorganic thin film layer caused the injection of holes.

At this time, the sputtering was performed under the following conditions: a sputtering gas of Ar (10 sccm), a substrate of 200°C, a film-forming rate of 5 nm/min., a sputtering pressure of 0.1 Pa, and an applied electric power of 100 W.

### Example 8

An element was produced in the same way as in Example 6 except an inorganic thin film layer of cerium oxide was fitted into the chamber. The inorganic thin film layer was formed into a film thickness of 3 nm. This inorganic thin film layer caused the injection of holes.

At this time, the sputtering was performed under the following conditions: a sputtering gas of Ar (10 sccm), a substrate of 200°C, a film-forming rate of 5 nm/min. , a sputtering pressure of 0.1 Pa, and an applied electric power of 100 W.

### Comparative Example 7

An element was produced in the same way as in Example 6 except that no inorganic thin film layer was formed.

Table 3 shows the evaluation results of the elements produced in Examples 6 to 8 and Comparative Example 7; the energy gaps of the inorganic thin film layers obtained from the measurement of the light absorption thereof; and the ionization potential values of the inorganic thin film layers obtained by measuring the starting powders with an under-atmosphere photoelectron spectroscopic device AC-1 manufactured by Riken Keiki Co., Ltd.

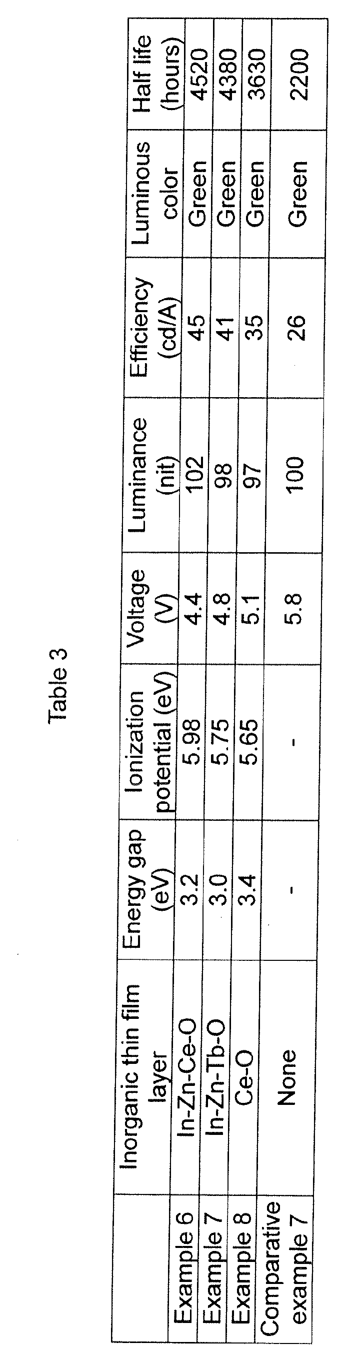

Table 3 shows that in the case of using the inorganic thin film layers having an ionization potential of 5.7 eV or more (Examples 6 and 7), the half life of the elements and the efficiency thereof were remarkably improved, compared with the case of using no inorganic thin film layer.

### Industrial Applicability

The present invention can provide an organic luminescence device which is driven at a low voltage, exhibits a high luminance and a high luminescence efficiency, and has an improved lifespan.

## Claims

1. An organic luminescence device comprising:
an anode;
an insulating or semiconductive inorganic thin film layer having an energy gap of 2.7 eV or more;
an organic compound layer comprising one or more layers which comprise at least an organic emitting layer, at least one of the layers containing an ortho-metallized metal complex; and
a cathode in order of the description of these members.

2. The organic luminescence device according to claim 1, wherein the inorganic thin film layer comprises one or more metals or compounds selected from metals, metal calcogenides, oxynitrides, carbides, nitrides, silicides and borides.

3. The organic luminescence device according to claim 2, wherein the metal(s) is/are one or more metals selected from the following A group; and the compound(s) is/are one or more calcogenides or nitrides;
A group: In, Sn, Ga, Si, Ge, Zn, Cd, Mg, Al, Ta and Ti.

4. The organic luminescence device according to claim 2, wherein the inorganic thin film layer comprises two or more selected from oxides, oxynitrides, carbides, and nitrides of In, Sn, Ga, Si, Al, Ta, Ti, Ge, Zn, Cd and Mg.

5. The organic luminescence device according to claim 2, wherein the inorganic thin film layer is made mainly of at least one of oxides of In, Sn and Ga.

6. The organic luminescence device according to claim 2, wherein the inorganic thin film layer is made mainly of (Si₁₋ₓGeₓ)O_{y} wherein 0 < x < 1, and 1.7 < y < 2.2.

7. The organic luminescence device according to claim 2, wherein the inorganic thin film layer comprises two or more of the metals or compounds, at least one of the metals or compounds having a work function of 4.5 eV or more.

8. The organic luminescence device according to claim 7, wherein the compounds are oxides, carbides, nitrides, silicides and borides.

9. The organic luminescence device according to claim 2, wherein the metals are two or more metals comprising one or more metals selected from the following A group; and one or more metals selected from the following B group;
A group: In, Sn, Ga, Si, Ge, Zn, Cd, Mg, Al, Ta and Ti;
B group: metals having a work function of 4.5 eV or more.

10. The organic luminescence device according to claim 9, wherein the metals in the B group are atoms belonging to any one of the groups IIIB, IVB, VB, VIB and VIIB in the periodic table (long period type).

11. The organic luminescence device according to claim 9, wherein the metals in the B group are Au, Ni, Cr, Ir, Nb, Pt, W, Mo, Ta, Pd, Ru, Ce, V, Zr, Re, Bi and Co.

12. The organic luminescence device according to claim 2, wherein the metals are two or more metals comprising at least one selected from the following C group;
C group: Ce, Pr, Nd, Sm, Eu, Gd, Tb, Dy, Ho, Er, Tm, Yb, and Lu.

13. The organic luminescence device according to claim 12, wherein the compounds are oxides, carbides, nitrides, silicides, and borides.

14. The organic luminescence device according to claim 2, wherein the metals are two or more metals comprising one or more metals selected from the following A group; and one or more metals selected from the following C group;
A group: In, Sn, Ga, Si, Ge, Zn, Cd, Mg, Al, Ta and Ti;
C group: Ce, Pr, Nd, Sm, Eu, Gd, Tb, Dy, Ho, Er, Tm, Yb, and Lu.

15. The organic luminescence device according to claim 1, wherein the inorganic thin film layer is made mainly of at least one oxide selected from oxides of Ce, Pr, Nd, Sm, Eu, Gd, Tb, Dy, Ho, Er, Tm, Yb, and Lu.

16. The organic luminescence device according to claim 1, wherein the inorganic thin film layer has a hole-injecting property.

17. The organic luminescence device according to claim 1, wherein the ionization energy of the inorganic thin film layer is more than 5.6 eV.

18. The organic luminescence device according to claim 1, wherein the ortho-metallized metal complex is an iridium complex.

19. The organic luminescence device according to claim 1, wherein the organic emitting layer comprises a polymer compound as a host material.

20. An organic emitting substrate wherein the organic luminescence device according to claim 1 is arranged on a plastic substrate.
